# EUROPÄISCHE PATENTSCHRIFT

(11) **EP 2 912 828 B1**
(45) Veröffentlichungstag und Bekanntmachung des Hinweises auf die Patenterteilung: **19.09.2018**
(21) Anmeldenummer: 13785401.4
(22) Anmeldetag: 25.10.2013
(51) Int. Cl.: H04L 29/08, G08G 1/16, H04L 29/06, G06F 17/50, G06K 9/62, H04W 4/80

(54) **VERFAHREN UND SYSTEM ZUR FUSION VON UMFELDSENSORDATEN MIT KOMMUNIKATIONSDATEN SOWIE VERWENDUNG DES SYSTEMS**
METHOD AND SYSTEM FOR MERGING ENVIRONMENT SENSOR DATA WITH COMMUNICATION DATA AND USAGE OF THE SYSTEM
PROCÉDÉ ET SYSTÈME DE FUSION DE DONNÉES DE CAPTEURS D'ENVIRONNEMENT AVEC DES DONNÉES DE COMMUNICATION, ET UTILISATION DE CE SYSTÈME

(30) Priorität: 26.10.2012 DE 102012219637
(43) Veröffentlichungstag der Anmeldung: 02.09.2015
(73) Patentinhaber: Continental Teves AG & Co. OHG, 60488 Frankfurt am Main (DE)
(72) Erfinder: STÄHLIN, Ulrich, 65760 Eschborn (DE); SCHERPING, Richard, 65835 Liederbach am Taunus (DE); GROTENDORST, Thomas, 65760 Eschborn (DE)
(86) Internationale Anmeldenummer: PCT/EP2013/072456
(87) Internationale Veröffentlichungsnummer: WO 2014/064280

(56) Entgegenhaltungen:
- DE-A1-102010 002 092
- DE-A1-102011 009 209
- ANDREAS RAUCH ET AL: "Analysis of V2X communication parameters for the development of a fusion architecture for cooperative perception systems", INTELLIGENT VEHICLES SYMPOSIUM (IV), 2011 IEEE, IEEE, 5. Juni 2011 (2011-06-05), Seiten 685-690, XP031998989, DOI: 10.1109/IVS.2011.5940479 ISBN: 978-1-4577-0890-9
- LONG LE ET AL: "Vehicular wireless short-range communication for improving intersection safety", IEEE COMMUNICATIONS MAGAZINE, IEEE SERVICE CENTER, PISCATAWAY, US, Bd. 47, Nr. 11, 1. November 2009 (2009-11-01), Seiten 104-110, XP011284161, ISSN: 0163-6804, DOI: 10.1109/MCOM.2009.5307473
- OLIVER SANDER ET AL: "Design of a Vehicle-to-Vehicle communication system on reconfigurable hardware", FIELD-PROGRAMMABLE TECHNOLOGY, 2009. FPT 2009. INTERNATIONAL CONFERENCE ON, IEEE, PISCATAWAY, NJ, USA, 9. Dezember 2009 (2009-12-09), Seiten 14-21, XP031599367, ISBN: 978-1-4244-4375-8
- "Intelligent Transport Systems (ITS); Vehicular Communications; Basic Set of Applications; Part 3: Specifications of Decentralized Environmental Notification Basic Service", TECHNICAL SPECIFICATION, EUROPEAN TELECOMMUNICATIONS STANDARDS INSTITUTE (ETSI), 650, ROUTE DES LUCIOLES ; F-06921 SOPHIA-ANTIPOLIS ; FRANCE, Bd. ITS WG1, Nr. V1.1.1, 1. September 2010 (2010-09-01), XP014061382,

## Beschreibung

Die Erfindung betrifft ein Verfahren zur Fusion von Umfeldsensordaten mit Kommunikationsdaten gemäß dem Anspruch 1, ein System zur Fusion von Umfeldsensordaten mit Kommunikationsdaten gemäß dem Anspruch 16 sowie eine Verwendung des Systems gemäß dem Anspruch 16. Aus dem Stand der Technik ist bereits die sogenannte Fahrzeug-zu-X-Kommunikation (Vehicle-2-X bzw. V2X) bekannt. Diese befindet sich gegenwärtig in einem fortgeschrittenen Entwicklungsstadium und ist Gegenstand verschiedener Standardisierungsverfahren, u.a. beim European Telecommunications Standards Institute (ETSI). Auch verschiedene Verfahren zur Umfeldsensordatenfusion sind im Stand der Technik zwar bereits bekannt, befinden sich aber dennoch weiterhin in der Entwicklung. Sowohl aktuelle V2X-Architekturen bzw.
V2X-Datenstrukturen bzw. V2X-Datenkörper, welche auch unter dem Begriff Intelligent Transportation Systems (ITS) bekannt sind, als auch eine Umfeldsensordatenfusion benötigen in der Regel eine Datenbank, die aus den jeweils empfangenen Nachrichten bzw. den erfassten Umfeldsensordaten Informationen sammelt und diese vorhält. Die bekannten und standardisierten V2X-Nachrichtentypen sind dabei z.B. periodisch von ITS-Kommunikationsteilnehmern gesendete Statusnachrichten (Cooperative Awareness Messages, CAMs) und ereignisbasierte Nachrichten (Decentrialized Environmental Notification Messages, DENMs). Darüber hinaus existieren weitere, spezielle Nachrichtentypen.

In diesem Zusammenhang beschreibt die DE 10 2010 002 092 A1 eine Datenvorverarbeitung für empfangene Fahrzeug-zu-X-Botschaften, welche einer Weiterleitung der Botschaften an die zugehörigen Anwendungen und Systeme im Fahrzeug sowie deren Verarbeitung durch diese Anwendungen und Systeme vorausgeht. Die Datenvorverarbeitung kann dabei die Überprüfung eines Sicherheitslevels der Botschaft umfassen und zusätzlich eine Datenreduktion ausführen. Die Datenreduktion bewirkt, dass Informationen über bestimmte Objekte oder Situationen ausgeblendet und entsprechend nicht weitergeleitet und verarbeitet werden. So werden etwa Informationen über Objekte, welche zu weit vom empfangenden Fahrzeug entfernt sind bzw. Informationen über Objekte, die vom Fahrzeug erst nach einer bestimmten Zeitspanne erreicht werden, nicht berücksichtigt. Ebenso werden viele örtlich nahe Objekte mit grundsätzlich gleichem Verhalten zu einer Situation zusammengefasst, z.B. zu einem Stau. Auch die ausschließliche Berücksichtigung von Objekten, welche sich im vorgesehenen Bewegungsschlauch des Fahrzeugs befinden, ist möglich. Die von den einzelnen Anwendungen zu verarbeitende Datenmenge kann dadurch deutlich reduziert werden.

Die DE 10 2008 060 231 A1 offenbart ein Verfahren zum Selektieren von unterschiedlichen, mittels Fahrzeug-zu-X-Kommunikation übertragenen Daten. Anhand eines Daten-Frames werden die empfangenen Daten von einem Datenfilter in der Empfangsvorrichtung unterschieden und beispielsweise an ein Fahrerassistenzsystem oder eine Unterhaltungseinrichtung weitergeleitet. Dies ermöglicht eine Sortierung der empfangenen Daten vor deren eigentlicher Verarbeitung. Zur Übertragung der Daten werden Sende- und Empfangseinrichtungen auf Basis der WLAN-Standards 802.11a/b/g/n bei 2,4 GHz bzw. 5.9 GHz oder des WLAN-Standards 802.11p bei 5,9 GHz genutzt. Um die Daten redundant zu übertragen und die Zuverlässigkeit der Übertragung zu steigern, ist auch ein gleichzeitiges Senden auf beiden WLAN-Frequenzbereichen möglich.
Aus der DE 10 2007 058 192 A1 ist eine Fusionierung von unterschiedlichen Umfeldsensoren, wie z.B. von Radarsensoren, Kamerasensoren, Lidarsensoren und auch einem Telematiksystem, welches hier ebenfalls als Umfeldsensor verstanden wird, bekannt. Mittels eines zentralen Steuergeräts werden die jeweils nicht-redundant erfassten Informationen eines Einzelsensors überprüft, indem sie analytisch mit Informationen eines anderen Sensors verglichen werden. Auf diese Weise kann ggf. eine Informationsredundanz hergestellt werden, welche die Basis für sicherheitsrelevante Eingriffe in die Fahrzeugsteuerung bildet.

Das Dokument DE102011009209 offenbart ein Verfahren zur Fusion von Umfeldsensordaten mit Kommunikationsdaten. Die aus dem Stand der Technik bekannten Verfahren und Vorrichtungen sind jedoch insofern nachteilbehaftet, als dass durch das rechenaufwändige Prüfen der Datenauthentizität und das nachfolgende Auswerten von empfangenen Fahrzeug-zu-X-Botschaften Latenzen entstehen, sofern die Fahrzeug-zu-X-Botschaften bzw. die in den Fahrzeug-zu-X-Botschaften enthaltenen Daten gemeinsam mit Umfeldsensordaten zu einem Umfeldmodell fusioniert werden sollen. Durch diese Latenzen ist das Umfeldmodell stets nur mit einer gewissen Verzögerung auf einem aktuellen Stand. Insbesondere falls Informationen aus dem Umfeldmodell als Grundlage für eine Bewarnung des Fahrers bzw. sogar für einen autonomen Steuereingriff herangezogen werden, kann durch die genannten Latenzen bzw. Verzögerungen eine bestehende kritische Situation weiter verschärft werden.
Die Aufgabe der vorliegenden Erfindung ist es daher, die im dem Stand der Technik vorherrschenden Nachteile zu vermeiden.

Diese Aufgabe wird erfindungsgemäß durch das Verfahren zur Fusion von Umfeldsensordaten mit Kommunikationsdaten gemäß Anspruch 1 gelöst.

Gemäß dem Verfahren der Erfindung zur Fusion von Umfeldsensordaten mit Kommunikationsdaten, wobei die Umfeldsensordaten mittels mindestens eines Umfeldsensors erfasst werden, werden die Kommunikationsdaten, die in Fahrzeug-zu-X-Botschaften enthalten sind, mittels Fahrzeug-zu-X-Kommunikationsmitteln empfangen. Das Verfahren zeichnet sich dadurch aus, dass vom Vorverarbeitungsprozess ausgewählte Kommunikationsdaten unmittelbar einem Sensordatenfusionsprozess zugeführt werden, wobei der Sensordatenfusionsprozess die ausgewählten Kommunikationsdaten mit Umfeldsensordaten zu einem Umfeldmodell fusioniert.

Daraus ergibt sich der Vorteil, dass die für ein Umfeldmodell relevanten Kommunikationsdaten nicht erst einer rechenlastigen Prüfung, Sortierung und Vorauswertung unterzogen werden, sondern unmittelbar dem Sensordatenfusionsprozess zugeführt werden. Somit werden gemäß dem Stand der Technik üblicherweise auftretende Latenzen und Verzögerungen vermieden.

Die Erfindung beschäftigt sich also mit der Integration der ITS-Architektur in Fahrzeuge, die bereits über Sicherheitsanwendungen (beispielweise Notbremsassistent und Spurassistent) verfügen und zusätzlich auf eine Umfeldsensordatenfusion (beispielsweise unter Nutzung eines Radars und einer Kamera) zurückgreifen können.

Innerhalb der Datenstruktur bzw. der Datenarchitektur bzw. der Datenkörper des sogenannten Kommunikationsstacks der ITS-Architektur ist ein Vorverarbeitungsprozess (Preprocessing) vorgesehen, welcher empfangene Fahrzeug-zu-X-Botschaften bzw. Kommunikationsdaten zur Verarbeitung innerhalb des Sensordatenfusionsprozesses weiterleitet, sofern die Kommunikationsdaten hierfür geeignet scheinen und ausgewählt werden. Dieser Vorverarbeitungsprozess ist dabei in Empfangsrichtung der Daten gesehen vor einem Datenverwaltungsprozess (Facilities) angeordnet.

Für den Vorverarbeitungsprozess können z.B. dem Fachmann bereits bekannte Verfahren eingesetzt werden. Eine weitere und neue Möglichkeit der Filterung innerhalb des Vorverarbeitungsprozesses stellt eine einfache Filterung nach Botschaftstypen dar, wobei bestimmte Botschaftstypen immer an den Umfeldsensordatenfusionsprozess weitergeleitet werden und andere Botschaftstypen nur an den Datenverwaltungsprozess weitergeleitet werden.

Durch den erfindungsgemäßen Abgriff der für den Sensordatenfusionsprozess relevanten Fahrzeug-zu-X-Botschaften vor dem Datenverwaltungsprozess werden somit die sonst übliche Latenzen vermieden, welche auftreten würden, wenn der Sensordatenfusionsprozess seinerseits Abfragen an den Datenverwaltungsprozess stellen würde.

Die Begriffe "Abfragen von Daten" und "Weiterführen von Daten" sind im Sinne der Erfindung synonym zu verstehen, da sie in jedem Falle den Datentransport von einem ersten Prozess zu einem nachfolgenden Prozess beschreiben. Ob es sich dabei um ein Abfragen durch den nachfolgenden Prozess handelt oder um ein Weiterführen durch den ersten Prozess ist im Sinne der Erfindung ohne Bedeutung und äquivalent.

Bevorzugt ist es vorgesehen, dass die ausgewählten Kommunikationsdaten vom Vorverarbeitungsprozess mit einer Datenmarkierung versehen werden. Daraus ergibt sich der Vorteil, dass Kommunikationsdaten, die vom Vorverarbeitungsprozess sowohl an den Datenverwaltungsprozess als auch an den Sensordatenfusionsprozess weitergeleitet werden, als redundant vorliegend erkennbar sind.

Weiterhin ist es bevorzugt, dass zumindest ein Anteil der Kommunikationsdaten vom Vorverarbeitungsprozess sowohl dem Sensordatenfusionsprozess als auch einem Datenverwaltungsprozess zugeführt wird.

Besonders bevorzugt werden sogar mehr als zwei Ausgänge des Datenverwaltungsprozesses realisiert. Beispielsweise kann zusätzlich zu einem Sensordatenfusionsprozess für Objekte ein Modul zur Erkennung von Verkehrszeichen und Lichtsignalanlagen bedient werden oder eine gitterbasierte Freiraumerkennung mit Daten versorgt werden, indem dafür relevante V2X-Botschaften herausgefiltert und weitergeleitet werden. Eine weitere Möglichkeit stellt eine Filterung nach Daten, die relevant für eine optische Darstellung für den Fahrer sind, dar.

Die Kommunikationsdaten werden nämlich besonders bevorzugt zusätzlich an den Datenverwaltungsprozess weitergeleitet, zumindest sofern es kommunikationsbasierte Anwendungsprozesse gibt, die diese verwenden, anstelle ausschließlich auf Umfeldsensordaten zurückzugreifen. Die übrigen, vom der Vorverarbeitungsprozess nicht als irrelevant gekennzeichneten, empfangenen Fahrzeug-zu-X-Botschaften bzw. Kommunikationsdaten werden anschließend an den Datenverwaltungsprozess weitergeleitet.

Durch eine erfindungsgemäß bevorzugte Auslegung des Vorverarbeitungsprozesses kann somit also eine einfache und effiziente Integration von unmittelbar weitergeleiteten Fahrzeug-zu-X-Botschaften in den bestehenden Sensordatenfusionsprozess erfolgen. Sofern sicherheitsrelevante Daten bzw. Fahrzeug-zu-X-Botschaften noch vor dem Datenverwaltungsprozess abgefragt werden, können die aktuellen Entwicklungsziele der potentiell sehr rechenzeitintensiven Funktionen des Datenverwaltungsprozesses hardwareseitig und softwareseitig mit geringeren ASIL-Anforderungen (Automotive Safety Integrity Level) erreicht werden. Dies ermöglicht eine Reduzierung der benötigten Rechenkapazität und damit der Herstellungskosten.

Zweckmäßigerweise ist es vorgesehen, dass heterogene Anwendungsprozesse, welche Informationen sowohl vom Sensordatenfusionsprozess als auch vom Datenverwaltungsprozess weitergeführt erhalten, redundant weitergeführte Informationen mittels der Datenmarkierung erkennen. Dadurch kann auch das unnötig doppelte Vorhalten von Daten vermieden werden.

Vorteilhafterweise ist es vorgesehen, dass unterschiedliche Datenformate empfangener Fahrzeug-zu-X-Botschaften in einem Dateneingangsprozess vereinheitlicht werden. Dadurch ergibt sich der Vorteil, dass die weitere Verarbeitung der Fahrzeug-zu-X-Botschaften bzw. der Kommunikationsdaten für die nachfolgenden Prozesse vereinfacht wird.

Alternativ bevorzugt kann die Vereinheitlichung der Datenformate - je nach verwendeten Übertragungswegen - auch erst im Vorverarbeitungsprozess erfolgen, da ggf. unterschiedliche Übertragungsprotokolle (z.B. TCP/IP im Mobilfunk vs. GeoRouting bei WLAN) verwendet werden, welche ein derartiges Vorgehen begünstigen.

Weiterhin ist es bevorzugt, dass die Kommunikationsdaten mittels des Dateneingangsprozesses und/oder des Vorverarbeitungsprozesses zu einem gemeinsamen Datenstrom zusammengeführt werden. Dies vereinfacht die nachfolgende Verarbeitung noch weiter.

Außerdem ist es vorteilhaft, dass mittels mindestens einer Vorverarbeitungsstufe, welche dem Dateneingangsprozess und einem Umfelddatenerfassungsprozess angegliedert ist, eine erste Filterung der Umfeldsensordaten und der Kommunikationsdaten erfolgt. Durch diese erste Filterung, welche der dem erfindungsgemäßen Vorverarbeitungsprozess vorangeht, können bereits irrelevante Kommunikationsdaten und irrelevante Umfeldsensordaten vor einer nachfolgenden Verarbeitung herausgefiltert werden. Somit wird für die nachfolgenden Prozesse weniger Rechenleistung benötigt.

Durch die verfahrensfrühzeitige Weiterleitung der Kommunikationsdaten bzw. der Fahrzeug-zu-X-Botschaften an den Sensordatenfusionsprozess ergibt sich der zusätzliche Vorteil, dass die erfindungsgemäß vorgesehenen Prozesse auf unterschiedliche Steuergeräte im Fahrzeug verteilt werden können. Dies vereinfacht die Implementierung des erfindungsgemäßen Verfahrens, da auf bereits vorhandene elektronische Rechenwerke der Steuergeräte zurückgegriffen werden kann.

Der Sensordatenfusionsprozess kann bei der erfindungsgemäß bevorzugten Auslegung der Datenkörper zur Kommunikation mit anderen Prozessen auf bekannte und bewährte Kommunikationsschnittstellen wie CAN zurückgreifen, da durch den Vorverarbeitungsprozess und ggf. weitere Vorverarbeitungsstufen die benötigte Datenbandbreite reduziert wird.

Je nach Aufteilung der verschiedenen erfindungsgemäßen Prozesse auf ein oder mehrere unterschiedliche Steuergeräte kann der Vorverarbeitungsprozess entweder verfahrensnah an den Netzwerk- und Transportprozess oder an den Datenverwaltungsprozess angebunden werden. Alternativ kann der Vorverarbeitungsprozess auch einzeln über bestehende Schnittstellen zwischen diesen Prozessen eingebunden werden.

Es ist zweckmäßig, dass mittels des Vorverarbeitungsprozesses eine zweite Filterung der Kommunikationsdaten erfolgt. Diese zweite Filterung erlaubt es, weitere Kommunikationsdaten auszufiltern, die nicht benötigt werden. Somit kann in nachfolgenden Prozessen nochmals Rechenleistung eingespart werden.

Bevorzugt ist es vorgesehen, dass die mittels des Vorverarbeitungsprozesses ausgewählten Kommunikationsdaten aufgrund ihrer Kopfdatenelemente ausgewählt werden. Die Kopfdatenelemente, die auch als sogenannte Headerinformationen bekannt sind, enthalten standardmäßig eine Reihe von Informationen, insbesondere unverschlüsselten Informationen, die eine Beurteilung und Bewertung der Fahrzeug-zu-X-Botschaften bzw. der Kommunikationsdaten sinnvoll ermöglichen. Beispiele für diese Informationen sind etwa die Position des Absenders, die Geschwindigkeit des Absenders und die Bewegungsrichtung des Absenders.

Weiterhin ist es bevorzugt, dass mittels des Vorverarbeitungsprozesses und der mindestens einen Vorverarbeitungsstufen die Umfeldsensordaten und die Kommunikationsdaten in eine der Kategorien kritisch, relevant und irrelevant eingestuft werden. Diese Einstufung vereinfacht die weitere Verarbeitung und ermöglicht es insbesondere, die Kommunikationsdaten bzw. deren Verarbeitung zu priorisieren.

Insbesondere ist es bevorzugt, dass als kritisch eingestufte Umfeldsensordaten und Kommunikationsdaten bevorzugt bearbeitet und/oder weitergeführt werden.

Außerdem ist es insbesondere bevorzugt, dass als irrelevant eingestufte Umfeldsensordaten und Kommunikationsdaten verworfen werden.

Vorteilhafterweise ist es vorgesehen, dass die Fahrzeug-zu-X-Kommunikationsmittel die Fahrzeug-zu-X-Botschaften mittels mindestens einer der folgenden Verbindungsarten austauschen:
- WLAN-Verbindung, insbesondere nach IEEE 802.11p,
- WiFi-Direct,
- ISM-Verbindung (Industrial, Scientific, Medical Band), insbesondere über eine funkverbindungsfähige Schließvorrichtung,
- Bluetooth-Verbindung,
- ZigBee-Verbindung,
- UWB-Verbindung (Ultra Wide Band),
- WiMax (Worldwide Interoperability for Microwave Access),
- Remote-Keyless-Entry-Verbindung,
- funkverbindungsfähige Schließvorrichtung,
- Mobilfunkverbindung, insbesondere GSM-, GPRS-, EDGE-, UMTS- und/oder LTE-Verbindungen und
- Infrarotverbindung.

Diese Verbindungsarten bieten dabei unterschiedliche Vorteile, je nach Art, Wellenlänge und verwendetem Datenprotokoll. So ermöglichen einige der genannten Verbindungsarten z.B. eine vergleichsweise hohe Datenübertragungsrate und einen vergleichsweise schnellen Verbindungsaufbau, andere hingegen eignen sich weitestgehend sehr gut zur Datenübertragung um Sichthindernisse herum. Durch die Kombination und gleichzeitige bzw. parallele Nutzung mehrerer dieser Verbindungsarten ergeben sich weitere Vorteile, da so auch Nachteile einzelner Verbindungsarten ausgeglichen werden können.

Zweckmäßigerweise ist es vorgesehen, dass die Umfeldsensoren ein oder mehrere Elemente aus der Gruppe
- Radarsensor,
- optischer Kamerasensor,
- Lidarsensor,
- Lasersensor,
- Ultraschallsensor,
- ESP-Sensor,
- ABS-Sensor und
- Neigungssensor
sind. Bei den genannten Sensoren handelt es sich um im Kraftfahrzeugbereich typischerweise verwendete Sensorgattungen, die im Wesentlichen eine umfassende Erfassung und Erkennung des Fahrzeugumfelds und des Fahrzeugzustands ermöglichen. Zum gegenwärtigen Zeitpunkt ist bereits eine Vielzahl von Fahrzeugen standardmäßig mit mehreren Sensoren der genannten Gattungen ausgestattet und diese Zahl wird in Zukunft aller Voraussicht nach weiter zunehmen. Der zusätzliche Ausrüstungsaufwand zur Implementierung des erfindungsgemäßen Verfahrens in ein Kraftfahrzeug ist daher gering.

Die Erfindung betrifft weiterhin ein System zur Fusion von Umfeldsensordaten mit Kommunikationsdaten, welches mindestens ein elektronisches Rechenwerk sowie Umfeldsensoren und Fahrzeug-zu-X-Kommunikationsmittel umfasst. Das System zeichnet sich dadurch aus, dass es das erfindungsgemäße Verfahren ausführt. Daraus ergeben sich die bereits beschriebenen Vorteile.

Die Erfindung betrifft außerdem eine Verwendung des erfindungsgemäßen Systems in einem Kraftfahrzeug.

Weitere bevorzugte Ausführungsformen ergeben sich aus den Unteransprüchen und der nachfolgenden Beschreibung eines Ausführungsbeispiels an Hand von Figuren.

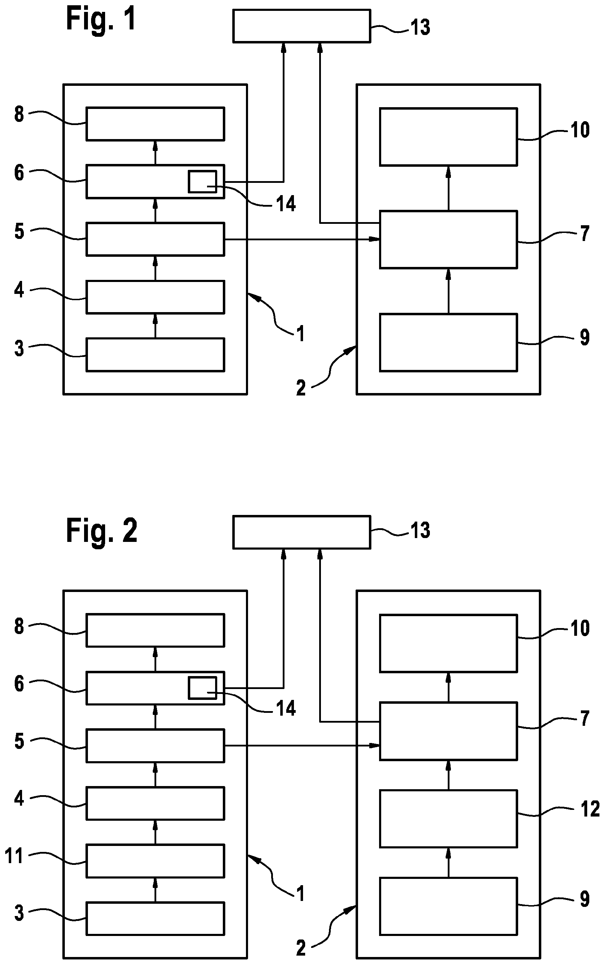

Es zeigt
- Fig. 1: eine mögliche Datenstruktur, die eine Ausführung des erfindungsgemäßen Verfahrens ermöglicht.

In Fig. 1 zeigt Kommunikationsdatenkörper 1 und Umfeldsensordatenkörper 2. Kommunikationsdatenkörper 1 umfasst zunächst Dateneingangsprozess 3, mittels dessen drahtlos empfangene Fahrzeug-zu-X-Botschaften als solche erkannt und erfasst werden. Beispielsgemäß werden die Fahrzeug-zu-X-Botschaften mittel Mobilfunk und WLAN empfangen. Von Dateneingangsprozess 3 werden die erfassten Fahrzeug-zu-X-Botschaften über Netzwerk- und Transportprozess 4 an Vorverarbeitungsprozess 5 weitergeführt. Vorverarbeitungsprozess 5 sortiert die erfassten Fahrzeug-zu-X-Botschaften und leitet diese je nach ihrer Relevanz bzw. ihren Verwendungsmöglichkeiten an Datenverwaltungsprozess 6 oder Sensordatenfusionsprozess 7 weiter. Indem Vorverarbeitungsprozess 5 bereits für Sensordatenfusionsprozess 7 relevante Fahrzeug-zu-X-Botschaften direkt an Sensordatenfusionsprozess 7 weiterleitet, müssen diese Fahrzeug-zu-X-Botschaften nicht in Datenverwaltungsprozess 6 verarbeitet werden. Dies reduziert die gegenüber dem Stand der Technik üblicherweise benötigte Rechenleistung des Datenverwaltungsprozesses deutlich. Trotzdem ist es auch weiterhin möglich, Fahrzeug-zu-X-Botschaften, die an Sensordatenfusionsprozess 7 weitergeleitet wurden, gleichzeitig auch an Datenverwaltungsprozess 6 weiterzuleiten, sofern diese Fahrzeug-zu-X-Botschaften auch für andere Anwendungen bzw. Prozesse relevant sind. Zusätzlich werden die erfassten Fahrzeug-zu-X-Botschaften von Vorverarbeitungsprozess 5 in eine der drei Kategorien "kritisch", "relevant" und "irrelevant" eingestuft, wobei als "irrelevant" eingestufte Fahrzeug-zu-X-Botschaften für Sicherheitssysteme und Sicherheitsanwendungen ohne Bedeutung sind. Datenverwaltungsprozess 6 umfasst seinerseits dynamischen Kartierungsprozess 14, welcher die Dateninhalte der erfassten Fahrzeug-zu-X-Botschaften sammelt, sortiert und ggf. an entsprechende kommunikationsbasierte Anwendungsprozesse 8 weiterleitet. Das in Fig. 1 mit dem Bezugszeichen 8 gekennzeichnete Element kann eine Vielzahl von unterschiedlichen Anwendungsprozessen umfassen.

Datenkörper 2 umfasst Umfelddatenerfassungsprozess 9, welcher mittels einer Vielzahl von Umfeldsensoren Umfeldsensordaten erfasst. Diese Umfeldsensordaten werden an Sensordatenfusionsprozess 7 weitergeführt und dort mit anderen Umfeldsensordaten und den von Vorverarbeitungsprozess 5 weitergeleiteten Fahrzeug-zu-X-Botschaften zu einem Umfeldmodell fusioniert. Von Sensordatenfusionsprozess 7 schließlich werden die fusionierten Daten an unterschiedliche sensordatenbasierte Anwendungsprozesse 10, wie z.B. einen autonomen Notbremsprozess, weitergeleitet.

Außerhalb von Datenkörper 1 und Datenkörper 2 sind außerdem heterogene Anwendungsprozesse 13 vorgesehen, welche sowohl Kommunikationsdaten von Datenverwaltungsprozess 6 als auch Umfeldsensordaten von Sensordatenfusionsprozess 7 weitergeführt bekommen. Beispielsgemäß handelt es sich bei heterogenen Anwendungsprozessen 13 u.a. um einen Ampelphasenassistenten, der sowohl über Fahrzeug-zu-X-Kommunikation als auch über einen Kamerasensor eine Zustandsinformation einer Ampel erfasst.

Fig. 2 zeigt eine Datenstruktur, welche der in Fig. 1 gezeigten Datenstruktur ähnlich ist, sich aber durch Vorverarbeitungsstufen 11 und 12 von dieser unterscheidet. Vorverarbeitungsstufe 11 ist dabei an Dateneingangsprozess 3 angegliedert und Vorverarbeitungsstufe 12 ist an Umfelddatenerfassungsprozess 9 angegliedert. Vorverarbeitungsstufen 11 und 12 klassifizieren die erfassten Fahrzeug-zu-X-Botschaften und die erfassten Umfeldsensordaten und filtern irrelevante Daten bzw. Informationen vor einer Weiterleitung dieser Daten bzw. Informationen an nachfolgende Prozesse heraus, so dass die notwendige Rechenleistung der nachfolgenden Prozesse im Vergleich zum Stand der Technik geringer bemessen sein kann. Somit ist die erfindungsgemäße Datenstruktur vergleichsweise einfach und kostengünstig umsetzbar und ausführbar.

Im Folgenden werden beispielhaft unterschiedliche Möglichkeiten der Verarbeitung eingehender Fahrzeug-zu-X-Botschaften beschrieben:
- Werden mehrere Übertragungskanäle mit unterschiedlichen Dateneingangsprozessen verwendet, so erfolgt eine Vereinheitlichung der Datenformate und ggf. bereits eine Zusammenführung der Kommunikationsdaten bzw. der Fahrzeug-zu-X-Botschaften im Rahmen des Dateneingangsprozesses.
- Eine Klassifikation basierend auf sogenannten Kopfdaten (Header) der Fahrzeug-zu-X-Botschaften filtert rechenzeiteffizient potentiell für den Sensordatenfusionsprozess relevante Nachrichten heraus. Dies sind vor allem CAMs, aus deren Angaben zu Position, Bewegungsrichtung und Geschwindigkeit sich die Relevanz auf einfache Weise bestimmen lässt.
- Enthält eine Fahrzeug-zu-X-Botschaft für den Sensordatenfusionsprozess relevante Daten und zusätzlich weitere, dasselbe Objekt beschreibende Daten, die vom Sensordatenfusionsprozess jedoch nicht verarbeitet werden können, so werden die jeweiligen Informationen parallel an den Datenverwaltungsprozess und an den Sensordatenfusionsprozess weitergeleitet. Eine dabei vergebene, eindeutige Datenmarkierung stellt sicher, dass eine Anwendung, die für bestimmte Funktionen auf beide Quellen (Datenverwaltungsprozess und Sensordatenfusionsprozess) zugreift, feststellen kann, dass es sich um ein und dasselbe beschriebene Objekt handelt.

## Patentansprüche

1. Verfahren zur Fusion von Umfeldsensordaten mit Kommunikationsdaten,
wobei die Umfeldsensordaten mittels mindestens eines Umfeldsensors erfasst werden und
wobei die Kommunikationsdaten in Fahrzeug-zu-X-Botschaften enthalten sind, welche mittels Fahrzeug-zu-X-Kommunikationsmitteln empfangen werden,
wobei von einem Vorverarbeitungsprozess (5) ausgewählte Kommunikationsdaten einem Sensordatenfusionsprozess (7) zugeführt werden, wobei der Sensordatenfusionsprozess (7) die ausgewählten Kommunikationsdaten mit Umfeldsensordaten zu einem Umfeldmodell fusioniert,
**dadurch gekennzeichnet, dass** die ausgewählten Kommunikationsdaten durch einen Abgriff der für den Sensordatenfusionsprozess (7) relevanten Kommunikationsdaten vor einem Datenverwaltungsprozess, ohne erst einer Prüfung, Sortierung und Vorauswertung unterzogen zu werden, unmittelbar zugeführt werden, wobei der Datenverwaltungsprozess seinerseits einen dynamischen Kartierungsprozess umfasst, welcher die Dateninhalte der empfangenen Fahrzeug-zu-X-Botschaften sammelt, sortiert und an entsprechende kommunikationsbasierte Anwendungsprozesse weiterleitet.

2. Verfahren nach Anspruch 1,
**dadurch gekennzeichnet, dass** die ausgewählten Kommunikationsdaten vom Vorverarbeitungsprozess (5) mit einer Datenmarkierung versehen werden.

3. Verfahren nach mindestens einem der Ansprüche 1 und 2,
**dadurch gekennzeichnet, dass** zumindest ein Anteil der Kommunikationsdaten vom Vorverarbeitungsprozess (5) sowohl dem Sensordatenfusionsprozess (7) als auch dem Datenverwaltungsprozess (6) zugeführt wird.

4. Verfahren nach mindestens einem der Ansprüche 2 bis 3,
**dadurch gekennzeichnet, dass** heterogene Anwendungsprozesse (13), die Informationen sowohl vom Sensordatenfusionsprozess (7) als auch vom Datenverwaltungsprozess (6) weitergeführt erhalten, redundant weitergeführte Informationen mittels der Datenmarkierung erkennen.

5. Verfahren nach mindestens einem der Ansprüche 1 bis 4,
**dadurch gekennzeichnet, dass** unterschiedliche Datenformate empfangener Fahrzeug-zu-X-Botschaften in einem Dateneingangsprozess (3) vereinheitlicht werden.

6. Verfahren nach Anspruch 5,
**dadurch gekennzeichnet, dass** die Kommunikationsdaten mittels des Dateneingangsprozesses (3) und/oder des Vorverarbeitungsprozesses (5) zu einem gemeinsamen Datenstrom zusammengeführt werden.

7. Verfahren nach mindestens einem der Ansprüche 5 bis 6,
**dadurch gekennzeichnet, dass** mittels mindestens einer Vorverarbeitungsstufe (11, 12), welche dem Dateneingangsprozess (3) und einem Umfelddatenerfassungsprozess (9) angegliedert ist, eine erste Filterung der Umfeldsensordaten und der Kommunikationsdaten erfolgt.

8. Verfahren nach mindestens einem der Ansprüche 1 bis 7,
**dadurch gekennzeichnet, dass** mittels des Vorverarbeitungsprozesses (5) eine zweite Filterung der Kommunikationsdaten erfolgt.

9. Verfahren nach mindestens einem der Ansprüche 1 bis 8,
**dadurch gekennzeichnet, dass** die mittels des Vorverarbeitungsprozesses (5) ausgewählten Kommunikationsdaten aufgrund ihrer Kopfdatenelemente ausgewählt werden.

10. Verfahren nach mindestens einem der Ansprüche 1 bis 9,
**dadurch gekennzeichnet, dass** mittels des Vorverarbeitungsprozesses (5) und der mindestens einen Vorverarbeitungsstufe (11, 12) die Umfeldsensordaten und die Kommunikationsdaten in eine der Kategorien kritisch, relevant und irrelevant eingestuft werden.

11. Verfahren nach Anspruch 10,
**dadurch gekennzeichnet, dass** als kritisch eingestufte Umfeldsensordaten und Kommunikationsdaten bevorzugt bearbeitet und/oder weitergeführt werden.

12. Verfahren nach Anspruch 10,
**dadurch gekennzeichnet, dass** als irrelevant eingestufte Umfeldsensordaten und Kommunikationsdaten verworfen werden.

13. Verfahren nach mindestens einem der Ansprüche 1 bis 12, **dadurch gekennzeichnet, dass** die Fahrzeug-zu-X-Kommunikationsmittel die Fahrzeug-zu-X-Botschaften mittels mindestens einer der folgenden Verbindungsarten austauschen:
- WLAN-Verbindung, insbesondere nach IEEE 802.11p,
- WiFi-Direct,
- ISM-Verbindung (Industrial, Scientific, Medical Band), insbesondere über eine funkverbindungsfähige Schließvorrichtung,
- Bluetooth-Verbindung,
- ZigBee-Verbindung,
- UWB-Verbindung (Ultra Wide Band),
- WiMax (Worldwide Interoperability for Microwave Access),
- Remote-Keyless-Entry-Verbindung,
- funkverbindungsfähige Schließvorrichtung,
- Mobilfunkverbindung, insbesondere GSM-, GPRS-, EDGE-, UMTS- und/oder LTE-Verbindungen und
- Infrarotverbindung.

14. Verfahren nach mindestens einem der Ansprüche 1 bis 13,
**dadurch gekennzeichnet, dass** die Umfeldsensoren ein oder mehrere Elemente aus der Gruppe
- Radarsensor,
- optischer Kamerasensor,
- Lidarsensor,
- Lasersensor,
- Ultraschallsensor,
- ESP-Sensor,
- ABS-Sensor und
- Neigungssensor
sind.

15. System zur Fusion von Umfeldsensordaten mit Kommunikationsdaten, umfassend mindestens ein elektronisches Rechenwerk, Umfeldsensoren und Fahrzeug-zu-X-Kommunikationsmittel, **dadurch gekennzeichnet,**
**dass** das System alle Schritte des Verfahrens nach mindestens einem der Ansprüche 1 bis 14 ausführt.

16. Verwendung des Systems nach Anspruch 15 in einem Kraftfahrzeug.

## Claims

1. A method for merging environment sensor data with communication data,
wherein the environment sensor data is detected by means of at least one environment sensor, and
wherein the communication data is contained in vehicle-to-X messages which are received by means of vehicle-to-X communication means,
wherein communication data selected by a pre-processing process (5) is fed to a sensor data merging process (7), wherein the sensor data merging process (7) merges the selected communication data with environment sensor data to form an environment model,
**characterised in that** the selected communication data is directly fed prior to a data management process by picking off the communication data which is relevant for the sensor data merging process (7), without first being subjected to checking, sorting and a preliminary evaluation, wherein the data management process comprises for its part a dynamic mapping process which collects, sorts and conveys the data contents of the received vehicle-to-X messages to suitable communication-based application processes.

2. The method according to Claim 1,
**characterised in that** the selected communication data is provided by the pre-processing process (5) with a data mark.

3. The method according to at least one of Claims 1 and 2, **characterised in that** at least a proportion of the communication data is fed by the pre-processing process (5) both to the sensor data merging process (7) and to the data management process (6).

4. The method according to at least one of Claims 2 to 3,
**characterised in that** heterogeneous application processes (13), which receive information forwarded both from the sensor data merging process (7) and from the data management process (6), recognise redundantly forwarded information by means of the data mark.

5. The method according to at least one of Claims 1 to 4, **characterised in that** different data formats of received vehicle-to-X messages are harmonised in a data entry process (3).

6. The method according to Claim 5,
**characterised in that** the communication data is merged by means of the data entry process (3) and/or the pre-processing process (5) to form a common data flow.

7. The method according to at least one of Claims 5 to 6,
**characterised in that** a first filtering of the environment sensor data and the communication data takes place by means of at least one pre-processing stage (11, 12) which is affiliated with the data entry process (3) and an environment data capturing process (9).

8. The method according to at least one of Claims 1 to 7, **characterised in that** a second filtering of the communication data takes place by means of the pre-processing process (5).

9. The method according to at least one of Claims 1 to 8, **characterised in that** the communication data selected by means of the pre-processing process (5) is selected on the basis of its header data elements.

10. The method according to at least one of Claims 1 to 9, **characterised in that** the environment sensor data and the communication data are classified in one of the categories critical, relevant and irrelevant by means of the pre-processing process (5) and the at least one pre-processing stage (11, 12).

11. The method according to Claim 10,
**characterised in that** environment sensor data and communication data classified as critical are preferably processed and/or forwarded.

12. The method according to Claim 10,
**characterised in that** environment sensor data and communication data which are classified as irrelevant are discarded.

13. The method according to at least one of Claims 1 to 12, **characterised in that** the vehicle-to-X communication means exchange the vehicle-to-X messages by means of at least one of the following types of connections:
- WLAN connection, particularly based on IEEE 802.11p,
- WiFi Direct,
- ISM (Industrial, Scientific, Medical Band) connection, particularly using a closing apparatus with radio connection capability,
- Bluetooth connection,
- ZigBee connection,
- UWB (Ultra-Wide Band) connection,
- WiMax (Worldwide Interoperability for Microwave Access),
- Remote Keyless Entry connection,
- Closing apparatus with radio connection capability,
- Mobile radio connection, particularly GSM, GPRS, EDGE, UMTS and/or LTE connections, and
- Infrared connection.

14. The method according to at least one of Claims 1 to 13,
**characterised in that** the environment sensors are one or more elements from the following group:
- Radar sensor,
- Optical camera sensor,
- Lidar sensor,
- Laser sensor,
- Ultrasonic sensor,
- ESP sensor,
- ABS sensor, and
- Inclination sensor.

15. A system for merging environment sensor data with communication data, comprising at least one electronic computer unit, environment sensors and vehicle-to-X communication means, **characterised in that**
the system carries out all of the steps of the method according to at least one of Claims 1 to 14.

16. Usage of the system according to Claim 15 in a motor vehicle.

## Revendications

1. Procédé pour la fusion de données de capteurs d'environnement et de des données de communication,
les données de capteurs d'environnement étant enregistrées à l'aide d'au moins un capteur d'environnement et
les données de communication étant contenues dans des messages de véhicule à X, lesquels sont reçus par des moyens de communication de véhicule à X,
des données de communication sélectionnées par un processus de prétraitement (5) étant amenées à un processus de fusion de données de capteurs (7), le processus de fusion de données de capteurs (7) fusionnant les données de communication sélectionnées et les données de capteurs d'environnement en un modèle d'environnement,
**caractérisé en ce que** les données de communication sélectionnées sont amenées directement par un prélèvement des données de communication pertinentes pour la processus de fusion de données de capteurs (7) avant un processus de gestion de données sans d'abord être soumises à un contrôle, un tri et une préanalyse, le processus de gestion de données comprenant lui-même un procédé de cartographie dynamique, lequel regroupe et trie les contenus de données des messages de véhicule à X reçus et les transmet à des processus d'application basés sur la communication correspondants.

2. Procédé selon la revendication 1,
**caractérisé en ce que** les données de communication sélectionnées sont munies d'un marquage de données par le procédé de prétraitement (5).

3. Procédé selon au moins l'une des revendications 1 et 2, **caractérisé en ce qu'**au moins une partie des données de communication est amenée aussi bien au processus de fusion de données de capteurs (7) qu'au processus de gestion de données (6) par le processus de prétraitement (5).

4. Procédé selon au moins l'une des revendications 2 à 3, **caractérisé en ce que** des processus d'application hétérogènes (13), lesquels reçoivent des informations transmises aussi bien par le processus de fusion de données de capteurs (7) que par le processus de gestion de données (6), reconnaissent les informations transmises de façon redondante à l'aide du marquage de données.

5. Procédé selon au moins l'une des revendications 1 à 4, **caractérisé en ce que** des formats de données différents de messages de véhicule à X reçus sont uniformisés au cours d'un processus d'entrée de données (3).

6. Procédé selon la revendication 5,
**caractérisé en ce que** les données de communication sont regroupées en un flux de données commun à l'aide d'un processus d'entrée de données (3) et/ou du processus de prétraitement (5).

7. Procédé selon au moins l'une des revendications 5 à 6, **caractérisé en ce qu'**un premier filtrage des données de capteurs d'environnement et des données de communication est exécuté à l'aide d'au moins une étape de prétraitement (11, 12), laquelle est rattachée à un processus d'entrée de données (3) et à un processus d'enregistrement de données d'environnement (9).

8. Procédé selon au moins l'une des revendications 1 à 7, **caractérisé en ce qu'**un deuxième filtrage des données de communication est exécuté au moyen du processus de prétraitement (5) .

9. Procédé selon au moins l'une des revendications 1 à 8, **caractérisé en ce que** les données de communication sélectionnées à l'aide du processus de prétraitement (5) sont sélectionnées en raison de leurs éléments de données d'en-tête.

10. Procédé selon au moins l'une des revendications 1 à 9, **caractérisé en ce que** les données de capteurs d'environnement et les données de communication sont classées dans une des catégories critiques, pertinentes et non pertinentes à l'aide du processus de prétraitement (5) et de l'au moins une étape de prétraitement (11, 12).

11. Procédé selon la revendication 10,
**caractérisé en ce que** les données de capteurs d'environnement et les données de communication classées comme étant critiques sont traitées et/ou transmises de façon préférentielle.

12. Procédé selon la revendication 10,
**caractérisé en ce que** les données de capteurs d'environnement et les données de communication classées comme étant non pertinentes sont rejetées.

13. Procédé selon au moins l'une des revendications 1 à 12, **caractérisé en ce que** les moyens de communication de véhicule à X échangent les messages de véhicule à X à l'aide de l'au moins un des modes de connexion suivants :
- connexion WLAN, en particulier conformément à IEEE 802.11p,
- Wi-Fi Direct,
- connexion ISM (bandes industrielle, scientifique, médicale), en particulier par un dispositif de fermeture capable de liaison radio,
- connexion Bluetooth,
- connexion ZigBee,
- connexion ULB (bande ultra-large),
- WiMAX (Worldwide Interoperability for Microwave Access),
- connexion par télédéverrouillage,
- dispositif de fermeture capable de liaison radio,
- connexion par téléphonie mobile, en particulier connexions GSM, GPRS, EDGE, UMTS et/ou LTE, et
- connexion infrarouge.

14. Procédé selon au moins l'une des revendications 1 à 13, **caractérisé en ce que** les capteurs d'environnement sont un ou plusieurs éléments parmi le groupe :
- capteur radar,
- capteur de caméra optique,
- capteur lidar,
- capteur laser,
- capteur à ultrasons,
- capteur ESP,
- capteur ABS et
- capteur d'inclinaison.

15. Système pour la fusion de données de capteurs d'environnement et des données de communication, comprenant au moins une unité arithmétique électronique, des capteurs d'environnement et des moyens de communication de véhicule à X. **caractérisé en ce que** le système exécute toutes les étapes du procédé selon au moins l'une des revendications 1 à 14.

16. Utilisation du système selon la revendication 15 dans un véhicule à moteur.
